# EUROPEAN PATENT APPLICATION

(11) **EP 3 125 304 A1**
(43) Date of publication of application: **01.02.2017**
(21) Application number: 15306245.0
(22) Date of filing: 30.07.2015
(51) Int. Cl.: H01L 31/0376, H01L 31/075, H01L 31/076, H01L 31/20

(54) **METHOD FOR MANUFACTURING SILICON BASED THIN FILM SOLAR CELLS WITH IMPROVED LIGHT INDUCED DEGRADATION PROPERTIES**

(71) Applicant: L'AIR LIQUIDE, SOCIETE ANONYME POUR L'ETUDE ET L'EXPLOITATION DES PROCEDES GEORGES CLAUDE, 75007 Paris (FR)
(72) Inventor: Goyal, Prabal, 91120 PALAISEAU (FR); Hong, Junegie, 91190 VILLIERS LE BACLE (FR); Urrejola, Ellias, 78150 LE CHESNAY (FR)
(74) Representative: Grout de Beaufort, François-Xavier

(57) **Abstract**

Method of forming an amorphous-silicon single layer to be applied in single, multi or tandem junction thin film solar cells, the method comprising at least the steps of:
- a) setting a substrate on a substrate holder inside a reactor chamber between an upper high frequency electrode and a bottom high frequency electrode, where the substrate is under high frequency power and differential of potential or voltage bias between both electrodes, where inter electrode distance is between 5mm to 50mm, preferably 11 mm;
- b) entering reaction gases comprising at least monosilane and hydrogen, with the addition of disilane, including:
∘ adjusting pressure values between 133 Pa to 1333 Pa, preferably 266 Pa of said chamber,
∘ supplying a high radio frequency of 13.56 MHz to 70 MHz for plasma ignition between upper and bottom electrodes of said chamber,
∘ creating an electrical discharge between both electrodes of said chamber, due to the applied high frequency power;

- c) applying a trigger power of high frequency plasma having a discharge power density of 400W/m² to 2020 W/m² to said electrodes for a short time of 1 to 15 seconds to ignite the plasma; and
- d) applying a lower power of high frequency plasma having a discharge power density of 40W/m² to 405W/m² to said electrodes for a good plasma cloud formation and thin film deposition.

## Description

The invention concerns a method of developing silicon-containing thin film layers with improved light induced degradation by mean of a gas mixture based on monosilane, disilane, and hydrogen under plasma enhanced chemical vapor deposition (PECVD) conditions.

Silanes are usually applied in thin film applications as silicon precursors for depositing amorphous and microcrystalline silicon by hydrogenation, as well as for crystalline photovoltaic applications by adding ammonia to the mixture. Hydrogenated a-Si:H is used as the top absorber layer in tandem configuration solar cell due to their high band gap of around 1.8eV. These layers are deposited by PECVD using radio frequency excitation. In the same manner, hydrogenated a-SiGe:H is often used as bottom absorber layer in tandem cell configurations due to their lower band gap around 1.5eV and good red light response compared to a-Si:H absorber layer. A higher band gap material is used for the top absorber compared to the middle and bottom absorber. Near to the surface, the short wavelength light (blue, 450-495nm) gets absorbed by a high band gap material such as a-Si:H (1.8eV).

Afterwards, higher wavelength light penetrates longer distances in the material and therefore lower band gap materials such as a-SiGe:H (1.5eV) is used to absorb the green light (495-570nm) spectrum. Finally, infrared light (700-1000nm) can penetrates further and in order to use its energy an even lower band gap material has to be used as µc-Si (1.1 eV). Each absorber layer included in a multi-junction solar cell performs optimal for a range of electromagnetic spectrum. The addition of the spectral response of all absorber layers together results on an optimal quantum efficiency approximated to the ideal sun spectrum.

A finalized solar cell will need better quality single layers to show better performance after light soaking compared to standard light induced degradation. Multi-junction solar cells are fabricated at the industry line, applying the concept of triple junction for further improve the light absorption of the wavelength spectrum.

Two advantages present thin film solar cells over crystalline solar cells, the most present technology on the market: they can be based on cheap (glass) or/and flexible substrates and they can be installed in diverse manners, because they are not strongly affected by shadow as crystalline modules. However, this technology suffers from a stronger degradation after light soaking compared to crystalline, where, for instance, n-type crystalline solar cells does not degrade at all; and this technology is not so well developed/studied as crystalline silicon [A. Smets, Growth related matrial properties of hydrogenated amorphous silicon, Ph.D. thesis 2002, TU/e].

Thin film solar cell structures reached a conversion efficiency up to 16.1% (record for 1 cm² active area triple junction a-Si:H/µc-Si:H/µc-Si:H [S. Kim, J-.W. Chung, H. Lee, J. Park, Y. Heo, H-.M. Lee, Remarkable progress in thin-film silicon solar cells using high-efficiency triple-junction technology, Sol. Ener. Mater. Sol. Cells 26 (119) 2013]). The initial efficiency drops significantly down to 13.4% and gets stabilized after light soaking. This is due to the well known problem of thin film materials explained as a defect generation due to recombination in the amorphous Si network immediately after deposition. Due to its amorphous structure the energy released by recombination generates more defects induced in the network, effect that is not observed in crystalline silicon solar cells. The defects are presents as microvoids or clusters and they can be analyzed by different techniques [K, F. et al. Structural Order and Staebler - Wronski Effect in Hydrogenated Amorphous Silicon Films and Solar Cells. Energy 4, 4-9 (2014)]. This issue is mainly due to an effect that compromises the quality of amorphous materials after light soaking and is well known as Staebler-Wronski effect (SWE) (D.L. Staebler and C.R. Wronski, Appl. Phys. Lett. 31, 292 (1977).

The Staebler-Wronski effect (SWE), a metastable light induced degradation (LID) effect, discovered in 1977 by D. Staebler and C. Wronski (D.L. Staebler and C.R. Wronski, Appl. Phys. Lett. 31, 292 (1977), is described as a significant decrease (down to 10 - 20 %) in dark conductivity and photoconductivity after light exposure of hydrogenated amorphous silicon (a-Si:H) material. Lots of studies have been carried out on this critical light induced degradation issue of a-Si:H material and its alloys (such as amorphous silicon germanium (a-SiGe:H) and amorphous silicon carbide (a-SiC:H)) since its discovery in the late 1970's. This issue mainly hinders thin film Si PV technology from being competitive against crystalline Si counterpart. For example, the record conversion efficiency of thin film Si solar cell (achieved with 1 cm² active area triple junction a-Si:H/µc-Si:H/µc-Si:H design [S. Kim, J-.W. Chung, H. Lee, J. Park, Y. Heo, H-.M. Lee, Remarkable progress in thin-film silicon solar cells using high-efficiency triple-junction technology, Sol. Ener. Mater. Sol. Cells 26 (119) 2013]) is 16.1% as initial efficiency and drops to 13.4% as stabilized efficiency. So, light soaking degradation from a-Si:H cells is quite significant. However, the exact mechanism of the SWE is still not well known in spite of theoretical and experimental progresses.

Since silicon network is essentially pre-determined by deposition conditions, several approaches have been tried to tune deposition parameters such as H₂/SiH₄ ratio, electrode spacing, plasma excitation frequency, deposition pressure, and substrate temperature in order to lower SiH₂ radicals and higher order silane clusters in the plasma which are considered as main contributors to the SWE. Especially, H₂ dilution with SiH₄ is found to be one of the most effective ways of mitigating the SWE, while not completely.

Use of disilane (Si₂H₆) in PECVD of a-Si:H materials definitely offers the advantage of high deposition rates: in literature, various a-Si:H films are deposited at higher growth rates with disilane addition without altering film quality, while influence of disilane on the SWE is not clear (not significant if any). For example, according to a study from Linde, the SWE depends primarily on deposition conditions (H₂/(SiH₄+Si₂H₆) gas ratio, RF power, and pressure) but not on Si source (silane or disilane). This result was based on a AMAT's AKT Gen5 PECVD platform at Malibu Solar (bankrupt in 2012) and their deposition rate with disilane addition was 2.5 to 3.0 Å/sec. It seems that disilane effect on the SWE depends on the deposition rate; at lower deposition rate, the effect of disilane on the SWE may be noticeable than at higher deposition rate. By optimizing the controllable PECVD parameters in addition of Si₂H₆, a better quality (less defects for the SWE) a-Si:H and a-SiGe:H films can be obtained with disilane addition compared to the conventional films deposited with monosilane.

Experimentally, outcome of the SWE is an increase of additional defect density of the a-Si:H material with light soaking [T. Shimizu, Staebler-Wronski effect in hydrogenated amorphous silicon and related alloy films, Japanese Journal of Applied Physics, 43 (3257) 2004]: Concentration of defects in a-Si:H material increases by up to two orders of magnitude with light soaking, reaching 10¹⁷ cm⁻³ after light soaking compared to 10¹⁵ cm⁻³ as-deposited. Therefore, much attention is given to uncovering the nature of the defects in the atomic structure of a-Si:H material. A typical a-Si:H structure consists of a presence of various defects such as un-passivated dangling bonds, vacancies, and voids, etc. Although a complete and coherent model for the degradation process is still lacking, it is common consensus that the presence of hydrogen within the a-Si:H structure plays a critical role in the creation mechanisms of these metastable defects. It is accepted that the SWE is related to a formation of extra dangling bonds upon illumination and hydrogen bonding configurations change as a result of light soaking. Therefore, it is very important to investigate the structural difference between as-deposited state and light soaked state for a-Si:H [J. Melskens et al (TU Delft), New insights in the Staebler-Wronski effect in hydrogenated amorphous silicon films and solar cells, 2013; In situ manipulation of the sub gap states in hydrogenated amorphous silicon, Solar Ener. Mater. Solar Cells (2014)].

Historically, one of the most favoured defect models for the nano/micro structure of a-Si:H has been the isolated hydrogen dangling bond defect [H. Fritzsche, Development in understanding and controlling the Staebler-Wronski effects in a-Si:H, Annual review of Materials Research, 47 (31) 2001; The structure of light-induced metastable defects in a-Si:H, J. of Non-Cryst. Sol. 180 (190) 1995; Photo-induced structural changes associated with the Staebler-Wronski effect in hydrogenated amorphous silicon, Sol. State Comm. 953 (94), 1995] in continuous random network (CRN). An electron-hole pair formed by the incident photon may recombine near a weak Si-Si bond, releasing sufficient energy to break the bond. A neighbouring hydrogen atom then forms a new bond with one of the Si atoms, leaving a dangling bond, which is basically unpassivated. These unpassivated dangling bonds can trap electron-hole pairs, act as recombination centres, thus reducing the device performance of a-Si:H resulting in the SWE. Another argument suggests that the SWE is a consequence of the existence of localized band-tail and mid-gap defect states in a-Si:H and therefore a truly intrinsic property of a-Si:H which unfortunately cannot be cured [M. Stutzmann, W.B. Jackson, and C.C. Tsai, Light-induced metastable defects in hydrogenated amorphous silicon: A systematic study, Physical Review B, 23 (32) 1985]. More recently, Smets et al (A. Smets, Growth related matrial properties of hydrogenated amorpous silicon, Ph.D. thesis 2002, TU/e) proposed that the SWE may be due to the exited microvoid centers in disordered network with hydrogenated vacancies such as divacancies, multivacancies, and nanosized voids, etc, which are considered to act as traps for the photo-excited charge carriers [Smets]. However, the challenges have been developing reliable experimental methods to measure the changes in sub-bandgap absorption (due to defect states) in a-Si:H material and relating these absorption states to the changes in nano/micro structure of a-Si:H material. With the help of sophisticated experimental techniques such as Doppler broadening positron annihilation spectroscopy (DB-PAS) and Fourier transform photocurrent spectroscopy (FTPS), at least four different defect (absorption) distributions have been recently measured in the a-Si:H sub-bandgap which represent the presence of divacancies, multivacancies, and nanosized voids [J. Melskens et al (TU Delft), New insights in the Staebler-Wronski effect in hydrogenated amorphous silicon films and solar cells, 2013]. The defects are presents as microvoids or clusters and they can be analyzed by different techniques as well [K, F. et al. Structural Order and Staebler - Wronski Effect in Hydrogenated Amorphous Silicon Films and Solar Cells. Energy 4, 4-9 (2014)]. This observation supports the anisotropic disordered network model rather than the isotropic continuous random network model (CRN), meaning that dangling bonds are not the only dominant defects in a-Si:H [C.R. Wronski, The limited relevance of SWE dangling bonds to degradation in high-quality a-Si:H solar cells, IEEE J. of Photovoltaics 4 (778) 2014].

As already stated, the SWE depends on the initial material quality of a-Si:H which depends on the deposition conditions and solar cell design such as silane dilution, electrode spacing, plasma excitation frequency, power, pressure, and absorber layer thickness, etc. Also, a number of other approaches towards the stable a-Si:H material have been tried such as lowering SiH₂ radicals in the plasma, use of amorphous/nanocrystalline super-lattice, and suppression of silane cluster in the plasma [Kondo, 1st IWESE (International workshop on the Staebler-Wronski Effect), April 2009].

Among the existing techniques to reduce the SWE is the possibility to dilute silane (SiH₄) with hydrogen (H₂) during the a-Si:H deposition. As a matter of fact, this method has been demonstrated to be very effective and is now widely used to mitigate the SWE. Strong dilution has been found to reduce the defect density and improve the stability of the a-Si:H material against the SWE. By increasing the hydrogen-to-silane gas flow ratio, R = [H₂]/[SiH₄], the surface coverage by hydrogen is increased allowing longer silicon precursors diffusion before settling into the amorphous structure. Therefore, the likelihood of forming energetically favorable bonds increases, which leads to an inter-atomic network which is less prone to defect and defect creation. Moreover, imposing a certain hydrogen dilution is believed to increase the structural order of the amorphous material by removing the weakest silicon-silicon bonds in the network and permitting growth radicals to reach energetic positions which are more favorable. Thus, the unstable bonds which are often associated with formation of band-tail states and mid-gap defect states in the amorphous material are, to a certain extent, removed during the deposition process due to increased hydrogen dilution ratio thanks to an etch effect [G. van Elzakker, Hydrogenated Amorphous Silicon Solar Cells Deposited From Silane Diluted with Hydrogen, Ph.D Thesis, Technische Universiteit Delft, Delft, 2010].

It is reported that the enhanced stability against the SWE is observed for the a-Si:H films deposited at dilution ratio up to R = 20 beyond which dilution does not result in a further increase of stability [G. van Elzakker, P. Sutta, M. Zeman, Structural properties of a-Si:H films with improved stability against light induced degradation, MRS proceedings, 1153, A18-02, 2009]. Further increase in hydrogen dilution may induce structural orders of the amorphous material and promote evolution towards microcrystalline silicon (µc-Si:H) [R.W. Collins, A.S. Ferlauto, G.M. Ferreira, C. Chen, J. Koh, R.J. Koval, Y. Lee, J.M. Pearce, C.R. Wronski, Sol. Ener. Mater. Sol. Cells, 78 (143) 2003], which in general does not suffer from the SWE.

Myung (S.Y. Myung, Fast light induced metastability and thermal recovery for protocrystalline silicon multilayers proved by sub-bandgap absorption spectra, Solar Energy 43 (106) 2014) reported a use of so-called protocrystalline silicon (pc-Si:H) for the enhanced stability against the SWE [Myung]. The pc-Si:H is referred to a unique hydrogen-diluted a-Si:H edge material existing just below the threshold of a-Si:H to µc-Si:H transition. Myung reported a variation of the sub-bandgap absorption specta for both pc-Si:H and a-Si:H film against light soaking. With increase of light soaking time, the sub-bandgap of pc-Si:H film is gradually increased, while the one of a-Si:H film shows a considerable enhancement in the sub-bandgap absorption against light soaking. This shows that the use of protocrystalline Si material can be a very effective mitigating solution to manage the SWE.

Significant improvements have been made in terms of understanding and better control of the silicon network. In fact, the silicon network is essentially pre-determined and pre-fixed by the deposition conditions. Through a rigorous optimization of PECVD process parameters (such as gas flow ratio, pressure, power, electrode spacing, and temperature, etc.), it can be possible to obtain an optimized structure of a-Si:H with less defects for the absorber and buffer layers used as the a-Si:H top cells in thin film silicon solar cells.

Practically speaking, the efforts to reduce the SWE may require to answer the following fundamental questions [A. Matsuda, M. Takai, T. Nishimoto, M. Kondo, Control of plasma chemistry for preparing highly stabilized amorphous silicon at high growth rate, Sol. Ener. Mater. & Sol. Cells, 3 (78) 2003]; how to find a specific network structure in a-Si:H causing the SWE, how to know the responsible reactive plasma species during film growth for the above-mentioned structure, and how to control these responsible species in the plasma and on the growing film surface, etc.

With a variety of plasma diagnostic tools (such as mass spectrometry, Langmuir probe, and optical emission spectroscopy) and surface analysis techniques (such as infrared laser absorption spectroscopy and infrared laser reflection absorption spectroscopy), Matsuda et al studied systematically these questions and found that the dihydride (Si-H₂) density in the plasma, electron temperature of the plasma, formation of silane polymers (such as SiₙH₂ₙ₊₂) and higher silane related reactive species (such as Si₄H₉) had a strong influence on the SWE [Matsuda]. For example, as density of Si-H₂ bond decreases in a-Si:H, stability against the SWE is improved [S. Shimizu, M. Kondo and A. Matsuda, A highly stabilized hydrogenated amorphous silicon film having very low hydrogen concentration and an improved Si bond network, Journal of Applied Physics, vol. 97, no. 3, 2005; and [Yoon] J.-H. Yoon and K.-T. Lee, Light-induced effects in hydrogenated amorphous silicon films grown from high hydrogen dilution of silane, Journal of Non-Crystalline Solids, 487 (299) 2002]. The contribution of higher silane related reactive species is found to be the most probable cause to increase the Si-H₂ bond density. The formation of silane polymers can lead to large size powders through a coagulation reaction of many silane polymers which eventually leads to a poor and less dense a-Si:H structure. Reduction of electron temperature in silane plasma is also found to be the key parameter to improve stability of the resulting a-Si:H.

Eventually, they discovered mitigation solutions for the SWE through a variation of controllable deposition parameters such as plasma-excitation frequency, pressure, electrode spacing, and hydrogen dilution, etc. At shorter electrode distance, formation of higher silane related reactive species is suppressed so stability of a-Si:H can be improved [H. Miyahara, M. Takai, T. Nishimoto, M. Kondo, A. Matsuda, electrode distance dependence of photo-induced degradation in hydrogenated amorphous silicon, Solar Ener. Mater. & Solar Cells 351 (74) 2002].

Very high plasma-excitation frequency (40 ∼120 MHz) and higher gas pressure are known in general as effective conditions to reduce electron temperature in the plasma to lower the plasma damage on the growing film. The increase of total pressure using hydrogen dilution is also one of the useful methods to reduce electron temperature in the plasma. With all these methods, they managed to deposit a stable a-Si:H material at high deposition rate of 2.0 nm/sec by optimizing the deposition parameters.

In case of a-Si:H alloys, the SWE also exists in hydrogenated amorphous silicon germanium (a-SiGe:H) thin films. The a-SiGe:H is the potential material to replace the lower bandgap absorber layer in multi junction solar cells such as a-Si:H/a-SiGe:H/µc-Si(Ge):H triple junction solar cells. It is reported that degradation kinetics between a-SiGe:H alloys and pure a-Si:H films are similar, especially for low Ge content films [M. Stutzmann, R.A. Street, C.C. Tsai, J.B. Boyce, S.E. Ready, J. Appl. Phys, 569 (66) 1989], while as the Ge concentration increases, photoconductivity upon light soaking degrades faster [M.E. Donertas, M. Gunes, J. Optoelectronics and Adv. Mater. 503 (7) 2005].

However, it is also observed that solar cells with protocrystalline silicon germanium (pc-SiGe:H) are stable against light exposure. This means that a stable a-SiGe:H material, for example, the edge a-SiGe:H material like pc-SiGe:H, can be obtained by tuning deposition conditions, which is similar to the a-Si:H case.

It has been shown already that disilane improves the deposition rate of amorphous silicon deposited by PECVD (Lahootun et al. Microcrystalline silicon thin film PECVD using hydrogen and silanes mixtures" EP 2740817 A1 (2014); and Hammad et al. PECVD of hydrogenated silicon thin films from SiH4+H2+Si2H6 mixtures, Thin solid films 451 (2004): 255-258). In both publications disilane was added to silicon precursor to improve deposition rate of the PECVD deposited thin film material. However, the quality of the film deposited at high deposition rates may not deliver a high quality amorphous material suitable for high efficiency thin film single/multijunction solar cell.

Overall, the deposition technology for optimized stability and high growth rate a-Si:H is one of the major research motivation for a-Si:H solar cell application. Thus the development of high growth rate of high quality film is crucial for solar cell application. The general challenge for the technology is simultaneous development of high throughput and high quality Si thin films. The requirements are often in conflict with each other.

The use of disilane (Si₂H₆) in the PECVD of a-Si:H films is reported to offer the advantage of high deposition rates, and therefore a large throughput for a production facility. However, it is also reported that fabricating high quality and high efficient devices at high deposition rates using disilane is considerably more difficult than making them at low deposition rates using monosilane. It is well known that the SWE is much more detrimental when a-Si:H is deposited at high growth rate. In addition, Si₂H₆ is also more prone to gas phase polymerization in the plasma than SiH₄, facilitating powder formation in the plasma, which is not good for depositing high quality and low defect a-Si:H film. However, a significant reduction of the incorporation of high order silanes (Si_{x>1}H_{y}) in the a-Si:H can lead to reduction in SWE. This was observed when one used a triode system by inserting a mesh to reduce formation of high order silane species in the plasma.

As a matter of fact, influence of Si₂H₆ addition to SiH₄/H₂ plasma on light induced degradation of PECVD µc-Si:H thin film has been recently investigated. [S. Gruss, S. Petri, H. Stiebig, P. Szych, J-C Cigal, A.M. Athalye, The status of research on disilane in silane gas mixtures in thin film silicon solar cells, page 2502, Proc. of 26th EU-PVSEC, 2013]. In this work, the effect of disilane on deposition rate was investigated on an industrial production-scale platform, an AMAT's AKT Gen 5 tool. Both a-Si:H and µc-Si:H thin films were deposited with disilane mixtures and were integrated into solar cells in order to investigate the influence of disilane on solar cell performance. They used special gas cylinders containing a mixture of 10% Si₂H₆ in SiH₄ as disilane source. Complete a-Si:H thin film solar cells were deposited with monosilane and 10% disilane mixtures. The p-layer of all the solar cells was always deposited with pure silane. The i-n-layers were deposited with silane or 10% disilane with different hydrogen dilution ratios. The i-n-layer thickness of all deposited solar cells was always kept constant, independent from deposition rate and Si precursor. The solar cells were stored in test rig for light degradation and their electrical parameters as a function of time (light irradiation) were measured. Solar cell energy conversion efficiencies (η) as a function of light irradiation time for solar cells deposited with silane and disilane are presented. The conversion efficiency loss is strongly dependent on deposition rate and does not depend significantly on silicon source (silane or 10% disilane mixture). So solar cells deposited with the same deposition rate degrade in a similar way independently from the precursor. The higher the deposition rate, the higher the light-induced degradation.

Some studies also show that, under optimized deposition conditions, a-Si:H films deposited from silane or disilane at the same deposition rate have similar properties. It has also been found that usage of disilane as a reactant gas enables high deposition rate without any changes in quality of the films for polycrystalline silicon material deposited by hot wire CVD. Kenne et al (J. Kenne, Y. Ohashi, T. Matsushita, M. Konagai, High deposition rate preparation of amorphous silicon solar cells by rf glow discharge decomposition of disilane, J. App. Phys. 560 (55) 2009) deposited a-Si:H films with disilane diluted in helium and found film properties similar to those of the conventional a-Si films prepared from monosilane. They concluded that disilane is applicable for mass production fabrication of a-Si:H solar cells [Kenne]. More positively, Hou et al found a high efficiency and highly stable a-Si:H material (with only 12.3% light soaking degradation) for solar cell deposited at high deposition rate (8 Å/sec) with disilane grading process [G. Hou, Q. Fan, X. Liao, C. Chen, X. Xiang, X. Deng, High-efficiency and higly stable a-Si:H solar cells deposited at high rate with disilane grading process, J. Vac. Sci. Tech A, 61201 (29) 2011]. A recent Ph.D thesis disclosed that solar cells with 10% Si₂H₆ additive, besides the enhanced growth rate (almost 3 times higher), behave the same as cell without additive in terms of initial or stabilized device performance after light soaking [] L. Zhu, plasma enhanced chemical vapour deposition of silicon thin films: Chracterization of film growth at different frequencies and gas compositions utilizing plasma diagnostics, Ph.D theis, 2014, University of Delaware.

The use of disilane in PECVD of Si thin films definitely offers an advantage of high deposition rates, while its effect on the SWE is not clear, namely, the addition of disilane additive has no negative or positive influence. In fact, the dissociation energy of disilane (Si-Si 76,7 kcal/mol) is lower than that of silane (Si-H 91,8 kcal/mol), so the dissociation rate of disilane in a plasma is higher which increases the electron and ion density in the plasma, leading to better silane dissociation and better gas utilization in general [Gruss]. In addition, the high energy electron concentration can be also reduced due to the Si₂H₆ ionization collisions, resulting in lower SiH* intensity. Thus, the discharge with Si₂H₆ additive has lower SiH* intensity but higher growth rate due to a difference in ionization cross section comparison for SiH₄ and Si₂H₆ [Zhu]. In conclusion, disilane is well known to support higher deposition rates of amorphous silicon, or amorphous silicon germane, however the quality of the film is not clear if remains.

The present invention concerns a method of developing amorphous silicon PECVD thin films on a substrate surface, comprising at least:
- A first step for setting a substrate on a substrate holder inside a reactor chamber between high frequency electrodes, where the substrate is under high frequency power and differential of potential (or voltage bias) between both electrodes, where inter electrode distance is between 5mm to 50mm, preferably 11 mm;
- A second step of entering precursor and reaction gases comprising at least monosilane and hydrogen, with the addition of disilane, including;
   ∘ adjusting pressure values between 133 Pa to 1333 Pa, preferably 266 Pa of said chamber,
   ∘ supplying a high radio frequency of 13.56 MHz to 70 MHz for plasma ignition between upper and bottom electrodes of said chamber,
   ∘ creating an electrical discharge between both electrodes of said chamber, due to the applied high frequency power;
- A third step applying a trigger power of high frequency plasma having a discharge power density of 400W/m² to 2020 W/m² to said electrodes for a short time of 1 to 15s to ignite the plasma; and
- A fourth step applying a lower power of high frequency plasma having a discharge power density of 40W/m² to 405W/m² to said electrodes for a good plasma cloud formation and thin film deposition.

According to other embodiments, the present invention concerns:
- A method as defined above, wherein said method is PECVD method.
- A method as defined above, wherein the first step includes a sub step of heating said substrate to a temperature range about 130°C to 250°C.
- A method according to anyone of preceding claims, wherein the second step includes a first substep of supplying a carrier gas into said chamber.
- A method as defined above, wherein the reaction gas comprises silane (SiH₄), and hydrogen mixture, with an addition of disilane Si₂H₆.
- A method as defined above, wherein hydrogen to monosilane ratio is comprised between 40 to 300, preferably between 40 and 70.
- A method as defined above, wherein hydrogen to silane to disilane ratio is comprised between 0 and 30, preferably 20.
- A method as defined above, wherein creating an electrical discharge is created between both electrodes of said chamber, due to the applied high frequency power.

### Problem solved by the invention:

The light soaking stability of hydrogenated amorphous silicon (a-Si:H) has been a major concern for thin film silicon solar cell development. Several investigations aimed to explain the light-induced degradation or Staebler Wronski effect [Staebler1977 : D.L. Staebler and C.R. Wronski, Reversible conductivity changes in discharge-produced amorphous Si, Appl. Phys. Lett. 31, 292 (1977)] in a-Si:H single films but still the exact reason is unknown. The structure of a-Si:H material is mainly controlled by the deposition parameters which impacts the reaction/plasma chemistry and therefore control the defects/species incorporated in a-Si:H layers. In this work the inventors show that disilane addition can be a solution to decrease the SWE phenomenon on amorphous face silicon based solar cells. The light induced degradation in the photovoltaic applications of silicon-based thin film solar cells can be improved by improving material quality of single and/or tandem and/or multijunction configuration.

This invention applies to plasma depositions including hydrogen, silane, and disilane mixtures. By adding (up to 20%) disilane (Si₂H₆) gas in the deposition precursor gas mixtures, one obtained a reduction of light induced degradation of the finished solar cells with the absorber layer deposited from the disilane addition up to by 50% relative.

In this work, single layers as a-Si:H are deposited by PECVD. The process requires a deposition temperature around 200°C, plasma power density between 30 to 880 W/m². The pressure can be used between 133 Pa and 1333 Pa. The silicon precursor is usually monosilane and furthermore we use disilane addition. These precursors are diluted in hydrogen in order to get control on the amorphous to crystalline phase within the material. The main objective of the inventors is then to find out if disilane improves the light induced degradation of the single layers and of the finished solar cells. In other words, the main objective is to show a decrease on the SWE phenomena, due to the improvement of the atomic restructuration of the thin film material.

A stable thin film material after light soaking is of paramount importance for photovoltaic industry. Disilane may show the path of improving chemically at the atomic level the properties of the film, while maintaining optical conditions constant (as band gap and refractive index).

The deposition technique of the invention is based on materials formed at lower deposition rate (<2 A/s). The inventors found reproducible and homogeneous results over a 10x10cm² glass substrate of 1mm thickness. Our PECVD reactor was optimized to work at low pressure (133 - 1333 Pa) and power (1-10W RF) in order to maintain plasma stability and high quality material. After deposition the material resistance was high showing no delamination or stress problem.

All depositions are performed in PECVD RF reactor. Disilane is added in 0 to 30% to the silane/hydrogen gas mixture and to the silane/hydrogen diluted gas mixture. Hydrogen/silicon dilution contemplates 300 to 40, where silicon is the total amount of silicon in the gas mixture containing silane and disilane., where silicon is the total amount of silicon in the gas mixture containing silane and disilane. Initial pressure of chamber before starting deposition is around 133.10⁻⁷ Pa. Then pressure of deposition is targeted between 133-1333 Pa. RF Plasma ignition covers from 400W/m² to 2020 W/m², while RF power for deposition covers 40W/m² to 405W/m² between electrodes. Substrate temperature covers from 100°C to 300°C. Deposition time covers from 10min to 2h, covering a deposition rate between 0.5 to 4A/s. Optical properties of the films are covered as follows: a-Si band gap above 1.65eV. Interelectrode gap is covered between 5mm to 50mm. all depositions are performed on glass and silicon wafers. All depositions are characterized by ellipsometry, Raman spectroscopy or Fourier-transform infrared (FT-IR) spectroscopy.

### EXAMPLES

After optimization of single layers applications on real solar cells were performed, incorporating the single layer in a p-i-n single junction solar cell. J-V characteristics of the solar cells were measured under 1 sun (0.1 W/cm²) at 25°C. The solar cells were light soaked at 2 suns at a temperature of 50°C for 100 hours.

The single layers were optimized for an adequate absorber. It means, we targeted 500nm a-Si:H thick layers. However different thicknesses are possible.

### 1) a-Si p-i-n single solar cell results on light induced degradation using disilane:

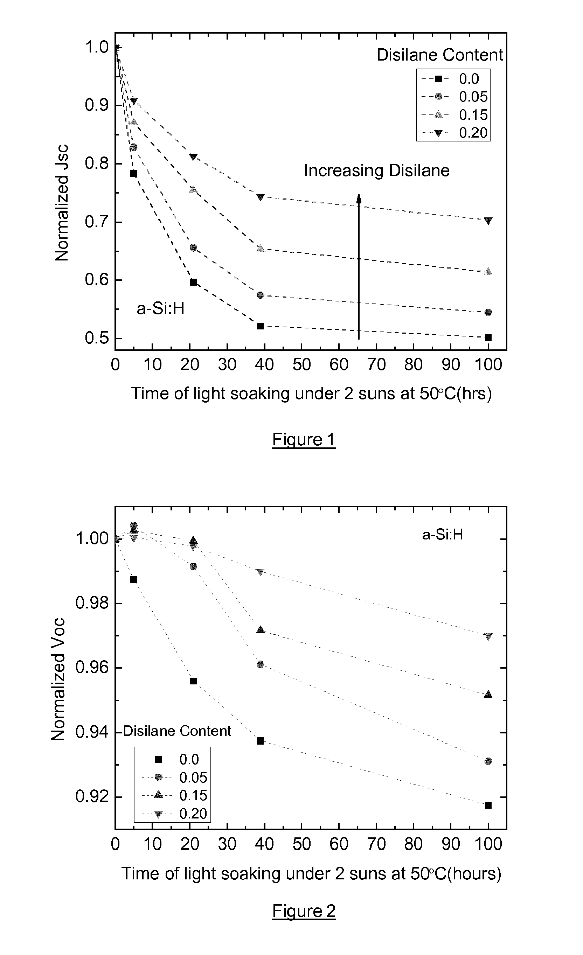

For a-Si:H, we found that the deposition rate increases as disilane increases. It increases from 0.67Å/s to 1.1 A/s as disilane increases from 0 to 0.25. This increase in deposition rate with the addition of disilane is possible due to more available Si-Si bonds in the film. We also found that the optical gap of a-Si:H layers was constant at ∼ 1.7 eV as disilane increases from 0 to 0.25. The J-V characteristic was measured after and before samples were light soaked under 2 suns at 50°C. The solar cell parameters (J_{SC} and V_{OC}) were recorded. To eliminate the substrate effects and small variations in the thickness of absorber layers, we report the normalized values of J_{SC} and V_{OC}. Figure 1 (Jsc degradation with light soaking time for single junction p-i-n a-Si:H solar cells, and improvement by disilane addition) shows the short circuit current (Jsc) degradation with light soaking time for single junction p-i-n a-Si:H solar cells, and improvement by disilane addition. Figure 2 shows the normalized values V_{OC} as function of time of light soaking under 2 suns at 50°C for p-i-n a-Si:H, and improvement by disilane addition. We see that Jsc of the solar cells degrade rapidly during the initial hours of light soaking and then stabilise at long hours of light exposure. This is possible because light soaking mainly affects the a-Si:H layer (absorber layer) in the solar cell. This absorber layer absorbs the incident light and is directly related to the J_{SC} in the solar cells. We also see that as the disilane content in gas phase increases, the degradation of J_{SC} is lesser compared to the case when disilane is not added. This suggests the positive effect of disilane possible because of reduction in high stretching mode content in the layers. However, figure 2 (Voc degradation with light soaking time for single junction p-i-n a-Si:H solar cells, and improvement by disilane addition) shows that Voc of the solar cells is relatively stable and degrades only to 0.92 (no disilane) even after 100 hours of light soaking. This is possible because the V_{OC} of the solar cells is mainly controlled by the p-type and n-type layer in the solar cell. The thickness of p-type layer (∼30nm) and n-type layer (∼20 nm) is low compared to a-Si:H layer (∼300 nm) and therefore LID effect should be less pre-dominant in p-type and n-type layer. Thus we see a very gradual change in V_{OC} of the solar cells.

### 2) FT-IR results for a-Si:H single layers, and explanation for LID improvement by disilane

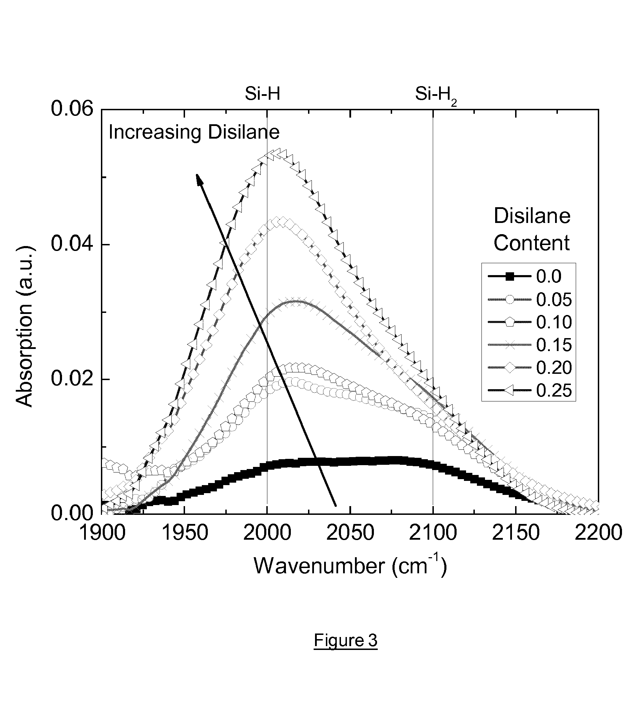

The FTIR Si-H stretching mode from 1900 - 2200 cm⁻¹ are used to characterize the Si-H bond in a-Si:H film; deconvolution into the low stretching mode (LSM) at 2000 cm⁻¹ and high stretching mode (HSM) at 2100 clm⁻¹. The LSM is regarded as the bulk Si-H monohydride vibration mode while the HSM as dyhydride or polyhydride Si-Hₓ bonds as well as surface Si-H bonds, which are used to estimate the defective or porous structure of a-Si:H film. The microstructure factor R_{mf} which is defined as the percentage of high stretching mode at 2100 cm⁻¹ of the entire Si-H stretching mode from 1900 cm⁻¹ to 2200 cm⁻¹. Consequently, the lower the R_{mf}, the better the quality of a-Si:H film. Figure 3 (Si-H and Si-H2 FT-IR peaks variation for a-Si:H single layers with disilane content increasing in the gas mixture) shows the LSM and HSM peaks measured by FT-IR and their shifting with increasing disilane content for a-Si:H single layers. As disilane content increases, the LSM peak (∼2000 cm⁻¹) becomes stronger while the HSM peak (∼2100 cm⁻¹) disappears eventually. This suggests that the amount of species incorporated in a-Si:H layers is different and varies according to the disilane content in the deposition gas mixture. Thus, disilane has a direct impact on improving chemically quality of the film.

## Claims

1. Method of forming an amorphous-silicon single layer to be applied in single, multi or tandem junction thin film solar cells, the method comprising at least the steps of:
- a) setting a substrate on a substrate holder inside a reactor chamber between an upper high frequency electrode and a bottom high frequency electrode, where the substrate is under high frequency power and differential of potential or voltage bias between both electrodes, where inter electrode distance is between 5mm to 50mm, preferably 11 mm;
- b) entering reaction gases comprising at least monosilane and hydrogen, with the addition of disilane, including:
∘ adjusting pressure values between 133 Pa to 1333 Pa, preferably 266 Pa of said chamber,
∘ supplying a high radio frequency of 13.56 MHz to 70 MHz for plasma ignition between upper and bottom electrodes of said chamber,
∘ creating an electrical discharge between both electrodes of said chamber, due to the applied high frequency power;
- c) applying a trigger power of high frequency plasma having a discharge power density of 400W/m² to 2020 W/m² to said electrodes for a short time of 1 to 15 seconds to ignite the plasma; and
- d) applying a lower power of high frequency plasma having a discharge power density of 40W/m² to 405W/m² to said electrodes for a good plasma cloud formation and thin film deposition.

2. A method according to claim 1, wherein said method is PECVD method.

3. A method according to claim 1 and 2, wherein the first step includes a sub step of heating said substrate to a temperature range about 130°C to 250°C.

4. A method according to anyone of preceding claims, wherein the second step includes a first substep of supplying a carrier gas into said chamber.

5. A method according to anyone of preceding claims, wherein the reaction gas comprises silane (SiH₄), and hydrogen mixture, with an addition of disilane Si₂H₆.

6. A method according to claim 5, wherein hydrogen to monosilane ratio is comprised between 40 and 300, preferably between 40 and 70.

7. A method according to claim 6, wherein hydrogen to silane to disilane ratio is comprised between 0 and 30, preferably 20.

8. A method according to claim 6, wherein creating an electrical discharge is created between both electrodes of said chamber, due to the applied high frequency power.
